# EUROPEAN PATENT SPECIFICATION

(11) **EP 2 827 383 B1**
(45) Date of publication and mention of the grant of the patent: **18.10.2017**
(21) Application number: 14177181.6
(22) Date of filing: 15.07.2014
(51) Int. Cl.: H01L 31/054, H02S 10/10

(54) **A hybrid solar energy converter**
Hybrider Solarenergiewandler
Convertisseur d'énergie solaire hybride

(30) Priority: 15.07.2013 PL 40470913
(43) Date of publication of application: 21.01.2015
(73) Proprietor: Akademia Gorniczo-Hutnicza im. Stanislawa Staszica w Krakowie, 30-059 Krakow (PL)
(72) Inventor: Wojciechowski, Krzysztof Tomasz, 32-082 Wieckowice (PL); Marszalek, Konstanty, 31-358 Krakow (PL)
(74) Representative: Kancelaria Eupatent.pl Sp. z.o.o

(56) References cited:
- EP-A1- 0 785 400
- WO-A1-2009/144700
- WO-A1-2010/136788
- WO-A2-2008/146287
- WO-A2-2010/147638
- WO-A2-2012/151215
- DE-A1-102005 054 364

## Description

### TECHNICAL FIELD

The present invention relates to conversion of solar energy to electric energy by a hybrid converter with photovoltaic cells and thermoelectric modules.

### BACKGROUND

Approximately half of the energy of full spectrum of solar radiation is comprised in ultraviolet (UV) and visible (VIS) frequencies, while the remaining part is comprised in near infrared (NIR) and mid-wavelength infrared (MWIR) frequencies. Photovoltaic cells, utilising photovoltaic effect, are one of the most efficient devices for converting solar energy into electric energy (electricity). The photovoltaic cells can be made of ceramic semiconductors, for example based on Si, Ge, Se or polymer materials.

The power efficiency of the most effective cells made of monocrystalline silicon exceeds 20%. One of the factors influencing the cell efficiency is a range of conversion of radiation, which for silicon cells is limited to the visible range (VIS, covering wavelengths (λ) from 380 to 720 nm), ultraviolet (UV, covering wavelengths 300 to 380 nm) and near-infrared (NIR, covering wavelengths from 720 to 1100nm). Infrared (IR) radiation having wavelength above 1100 nm is not converted to electrical energy by a p-n semiconductor junction responsible for the photovoltaic effect, and causes only heating of the cell. This is disadvantageous, as it significantly decreases the photovoltaic cell efficiency.

The Polish patent PL 203881 discloses a photovoltaic cell integrated with a heat exchanger that receives the heat of the cell and transfers it to a working liquid.

Common thermoelectric modules are able to convert thermal energy into electrical energy with 5% efficiency when the temperature difference between the cold and the hot side of the module is about 200°C.

A hybrid solution, directly combining a photovoltaic cell with a thermoelectric module, could seemingly allow for a significant increase of efficiency. However, theoretical calculations and practical experiments have shown that such solution is prone to the above-mentioned negative effect of efficiency loss of photovoltaic cells related to temperature increase.

A US patent application US2012048322 discloses a hybrid solar converter which addresses the above-mentioned problem by structurally separating the photovoltaic cell from the thermoelectric module. It comprises a concave mirror for focusing solar radiation on a selective, reflecting-transmitting mirror located at its focus point. The mirror reflects UV and VIS radiation and is transparent to IR radiation. The IR radiation is incident on a thermoelectric module located behind the mirror. The cold side of the thermoelectric module is coupled with a radiator for heating a working liquid. The UV and VIS radiation reflected from the mirror is directed through a hole in the mirror towards a photovoltaic cell. The total electric power of the converter is approximately a sum of the power of the photovoltaic cell and the thermoelectric module. The overall energy efficiency is increased by collection of the heat by the radiator of the thermoelectric module. However, the electrical energy generated in the photovoltaic cell is significantly reduced by the fact that the reflected UV and VIS radiation is focused in the axis of the concave mirror. This narrows the area of solar energy transformation and focuses the energy on a small area. Another hybrid solar converter is known from patent publication DE 10 2005 054 364 A1.

### SUMMARY

There is presented a hybrid converter of solar energy according to claim 1, the converter comprising: a selective concave mirror configured to focus solar radiation; a thermoelectric module located at a focus point of the concave mirror; a radiator for cooling the working liquid flow adjacent to a cold surface of the thermoelectric module; and a set of photovoltaic cells located behind the concave mirror with respect to the sun, covering at least a section of the surface of the selective concave mirror (1). The selective concave mirror is reflective for infrared (IR) radiation of electromagnetic waves of wavelength greater than 1,1 µm and is transparent to ultraviolet (UV), visible (VIS) and

near-infrared (NIR) radiation of wavelength from 0,72 to 1,1 µm; and the photovoltaic cells are located such that they cover the area of the projection of the whole surface of the concave mirror.

Preferably, the concave mirror is made of transparent glass covered with a transparent semiconductor coating made of metals and/or metal oxides, preferably indium-tin oxides ITO.

Preferably, the concave mirror has a parabolic or semi-cylindrical or cylindrically-parabolic shape. The concave mirror is made of a semiconductor coating applied on the inner, transparent surface of a glass pipe, in the range of a central angle smaller than 90⁰, wherein the bisector of the concave mirror is directed at the thermoelectric module, mounted in a geometric axis of the pipe, and wherein the thermoelectric module has its hot surface coated with an infrared absorber and its cold surface connected with the radiator

Preferably, the converter comprises a silicon photovoltaic cell located behind the concave mirror and distanced from the concave mirror by an air-gap.

Preferably, the external surface of the pipe, in the range of the central angle of the concave mirror, is coated with a thin layer photovoltaic cell, made of CdTe or a:Si.

Preferably, only a section of the surface of the mirror is covered with photovoltaic cells.

Preferably, the whole surface of the mirror is covered with photovoltaic cells.

### BRIEF DESCRIPTION OF FIGURES

The present invention is shown by means of exemplary embodiments on a drawing, in which:
Fig. 1 shows a schematic diagram of the converter,
Fig. 2 shows an example embodiment utilizing a glass pipe
Fig. 3 shows a section of a surface panel comprising pipe converters of Fig. 2.

### DETAILED DESCRIPTION

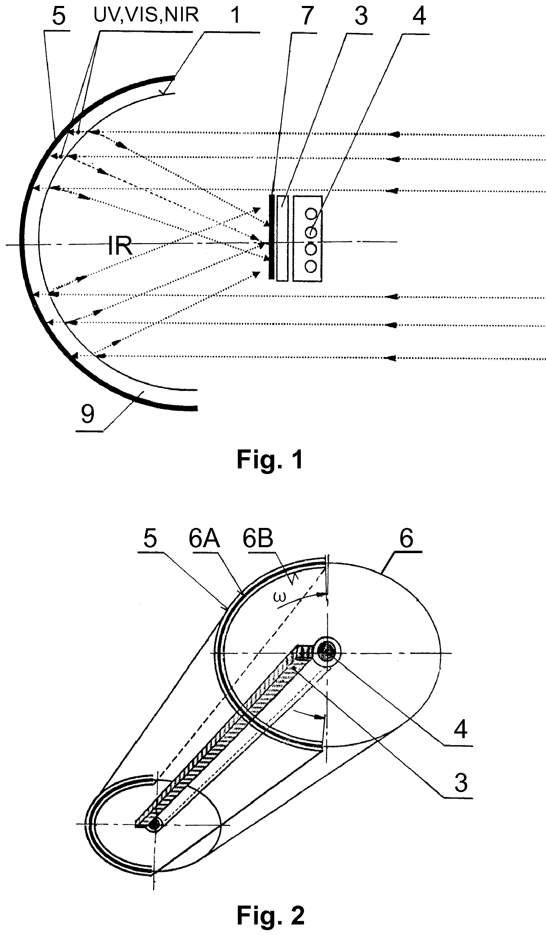

The solar converter comprises a selective concave mirror 1 configured to focus solar radiation and being reflective to IR radiation (wavelengths greater than 1,1 µm) and transparent to UV and VIS (and preferably NIR) radiation (wavelengths from 0,72 to 1,1 µm). The selective concave mirror 1 may be formed as two separate elements, as a layered element (as explained in the embodiment of Fig. 2) or as a single uniform element. A set of photovoltaic cells 5 is located behind (with respect to the sun) the concave mirror 1, on its whole projecting surface. In other words, photovoltaic cells 5 are located behind the concave mirror 1 with respect to the focus point of the mirror 1. A thermoelectric module 3 is located at the focus point of the concave mirror 1. The hot surface of the thermoelectric module 3 is coated with a layer of an infrared absorber 7. A radiator 4, coupled with a working liquid flow, is coupled with the cold surface of the thermoelectric module 3.

As shown in the embodiment of Fig. 2, the selective concave mirror 1 can be formed by a section 6A (marked by a bold line) of a transparent glass pipe 6, the section 6A having the central angle ω of the inner surface smaller than 90°, and having the inner surface coated by indium tin oxide (ITO) layer 6B. In other embodiments, other coating metal and/or matal oxide layers 6B may be used. The thermoelectric module 3 is located on the bisector of the central angle ω, in the geometrical axis of the pipe 6. The hot surface of the module 3 is coated with an infrared absorber layer 7. The cold surface of the module 3 is connected with the radiator 4 coupled with a working liquid flow or an air radiator.

The photovoltaic cell 5, preferably made of monocrystalline silicon, is located outside the pipe 6 at a distance of an air-gap 9, which may be 2 mm, in the range of projection of the central angle ω of the concave mirror 1. The photovoltaic cell may be of a thin-layer type, made for example from CdTe, formed as a coating on the external surface of the pipe 6 in the range of the central angle ω. In another embodiment, a silicon photovoltaic cell may be applied on the external surface of the pipe 6 within the range of the central angle ω as a thin layer, made for example from CdTe or a:Si.

In other embodiments, the concave mirror 1 may have a parabolic or cylindrically-parabolic shape.

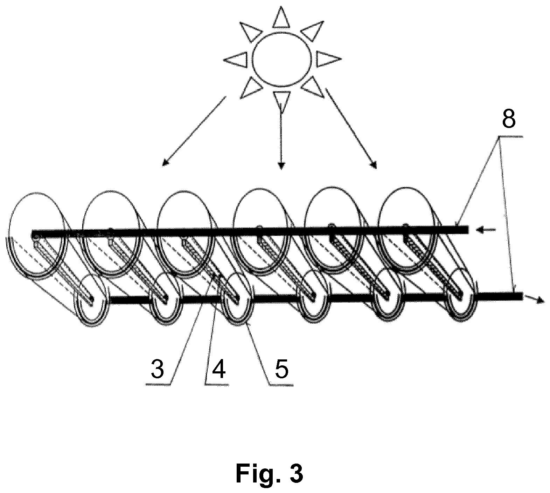

Fig. 3 presents a panel comprising a plurality of pipes 6 arranged in parallel within a frame. The pipes 6 comprise photovoltaic cells 5 and thermoelectric modules 3. The radiators of the thermoelectric modules 3 are connected to collectors 8 of the working liquid flow, for example collectors of a water heater.

The efficiency of conversion of electromagnetic radiation energy depends on the angle of incidence of the waves. It may depend on the day period (morning, noon, evening), on the season (winter, summer) as wells as the latitude (equator countries, near-poles countries). Therefore, the semiconductor surface or the glass panels may be structured such as to decrease this angular dependency of efficiency.

In another embodiment, only a fragment of the mirror 1 surface is covered with photovoltaic cells 5.

In the converter presented herein, the energy is converted first in the photovoltaic modules, which are located on a large area and receive UV, VIS and NIR radiation, which penetrates via the whole surface of the concave mirror. The applied sequence of convertion of solar radiation with a use of high-efficiency photovoltaic and thermoelectric materials allows achieving increase of efficiency of solar energy conversion into electrical energy.

## Claims

1. A hybrid converter of solar energy, the converter comprising:
- a selective concave mirror (1) configured to focus solar radiation;
- a thermoelectric module (3) located at a focus point of the selective concave mirror (1);
- a radiator (4) for cooling the working liquid flow adjacent to a cold surface of the thermoelectric module (3); and
- a set of photovoltaic cells (5);
the converter being **characterized in that**:
- the selective concave mirror (1) is made of a semiconductor coating (6B) applied on the inner, transparent surface (6A) of a glass pipe (6), in the range of a central angle (ω) smaller than 90⁰, wherein the bisector of the concave mirror (1) is directed at the thermoelectric module (3), mounted in a geometric axis of the pipe (6), and wherein the thermoelectric module (3) has its hot surface coated with an infrared absorber (7) and its cold surface connected with the radiator (4);
- the selective concave mirror (1) is reflective for infrared (IR) radiation of electromagnetic waves of wavelength greater than 1,1 µm and is transparent to ultraviolet (UV), visible (VIS) and near-infrared (NIR) radiation of wavelength from 0,72 to 1,1 µm; and
- the photovoltaic cells (5) cover at least a section of the surface of the selective concave mirror (1) opposite to the focus point of the selective concave mirror (1) on the external surface of the pipe (6), in the range of the central angle (ω) of the concave mirror (1).

2. The converter according to claim 1, **characterized in that** the concave mirror (1) is made of transparent glass covered with a transparent semiconductor coating made of metals and/or metal oxides, preferably indium-tin oxides ITO.

3. The converter according to claim 1 **characterized in that** the concave mirror (1) has a parabolic or semi-cylindrical or cylindrically-parabolic shape.

4. The converter according to claim 1 **characterized in that** it comprises a silicon photovoltaic cell (5) located behind the concave mirror (1) and distanced from the concave mirror (1) by an air-gap (9).

5. The converter according to claim 1 **characterized in that** the set of photovoltaic cells (5) is formed by coating the external surface of the pipe (6) with a thin layer photovoltaic cell made of CdTe or a:Si.

6. The converter according to claim 5 **characterized in that** the whole surface of the mirror (1) is covered with photovoltaic cells (5).

## Patentansprüche

1. Hybridumwandler von Solarenergie, wobei der Umwandler Folgendes umfasst:
- einen selektiven konkaven Spiegel (1), der konfiguriert ist, um Sonneneinstrahlung zu fokussieren;
- ein thermoelektrisches Modul (3), das sich an einem Fokuspunkt des selektiven konkaven Spiegels (1) befindet;
- einen Kühler (4) zum Kühlen des Arbeitsflüssigkeitsstroms neben einer kalten Oberfläche des thermoelektrischen Moduls (3); und
- einen Satz an Photovoltaikzellen (5);
wobei der Umwandler **dadurch gekennzeichnet ist, dass**:
- der selektive konkave Spiegel (1) aus einer Halbleiterbeschichtung (6B) gefertigt ist, die auf die innere, transparente Oberfläche (6A) eines Glasrohrs (6) aufgetragen wird, in der Spanne eines Mittelpunktswinkels (ω), der kleiner als 90° ist, wobei der Bisektor des konkaven Spiegels (1) auf das thermoelektrische Modul (3) gerichtet ist, angebracht in einer geometrischen Achse des Rohrs (6), und wobei die heiße Oberfläche des thermoelektrischen Moduls (3) mit einem Infrarotabsorber (7) beschichtet ist und seine kalte Oberfläche mit dem Kühler (4) verbunden ist;
- der selektive konkave Spiegel (1) reflektiv für Infrarot-(IR)-Strahlung an elektromagnetischen Wellen mit einer Wellenlänge von mehr als 1,1 µm ist und für Ultraviolett-(UV)-, sichtbare (VIS) und Nahinfrarot-(NIR)-Strahlung mit einer Wellenlänge von 0,72 bis 1,1 µm transparent ist; und
- die Photovoltaikzellen (5) zumindest einen Abschnitt der Oberfläche des selektiven konkaven Spiegels (1) gegenüber dem Fokuspunkt des selektiven konkaven Spiegels (1) an der externen Oberfläche des Rohres (6) bedecken, in der Spanne des Mittelpunktswinkels (ω) des konkaven Spiegels (1).

2. Umwandler nach Anspruch 1, **dadurch gekennzeichnet, dass** der konkave Spiegel (1) aus transparentem Glas gefertigt ist, das mit einer transparenten Halbleiterbeschichtung bedeckt ist, die aus Metallen und/oder Metalloxiden, bevorzugt Indium-Zinn-Oxiden, ITO, hergestellt ist.

3. Umwandler nach Anspruch 1, **dadurch gekennzeichnet, dass** der konkave Spiegel (1) eine parabelförmige oder halbzylindrische oder zylindrisch-parabelförmige Form aufweist.

4. Umwandler nach Anspruch 1, **dadurch gekennzeichnet, dass** er eine Silizium-Photovoltaikzelle (5) umfasst, die sich hinter dem konkaven Spiegel (1) befindet und durch eine Luftlücke (9) von dem konkaven Spiegel (1) beabstandet ist.

5. Umwandler nach Anspruch 1, **dadurch gekennzeichnet, dass** der Satz an Photovoltaikzellen (5) durch Beschichten der externen Oberfläche des Rohres (6) mit einer Dünnschichtphotovoltaikzelle, hergestellt aus CdTe oder a:Si, gebildet wird.

6. Umwandler nach Anspruch 5, **dadurch gekennzeichnet, dass** die gesamte Oberfläche des Spiegels (1) mit Photovoltaikzellen (5) bedeckt ist.

## Revendications

1. Convertisseur hybride d'énergie solaire, le convertisseur comprenant :
- un miroir concave sélectif (1) configuré pour focaliser les rayons du soleil ;
- un module thermoélectrique (3) localisé à un point de focalisation du miroir concave sélectif (1) ;
- un radiateur (4) destiné à refroidir le flux de liquide de travail adjacent à une surface froide du module thermoélectrique (3) ; et
- un ensemble de cellules photovoltaïques (5) ;
le convertisseur étant **caractérisé en ce que** :
- le miroir concave sélectif (1) est constitué d'un revêtement semiconducteur (6B) appliqué sur la surface interne transparente (6A) d'un tube de verre (6), dans la portée d'un angle central (ω) inférieur à 90°, dans lequel la bissectrice du miroir concave (1) est dirigée au niveau du module thermoélectrique (3), monté sur un axe géométrique du tube (6), et dans lequel le module thermoélectrique (3) a sa surface chaude revêtue d'un absorbant de rayonnement infrarouge (7) et sa surface froide raccordée au radiateur (4) ;
- le miroir concave sélectif (1) est réfléchissant au rayonnement infrarouge (IR) d'ondes électromagnétiques de longueur d'onde supérieure à 1,1 µm et est transparent au rayonnement ultraviolet (UV), visible (VIS) et dans le proche infrarouge (NIR) de longueur d'onde allant de 0,72 à 1,1 µm ; et
- les cellules photovoltaïques (5) recouvrent au moins une partie de la surface du miroir concave sélectif (1) en regard du point de focalisation du miroir concave sélectif (1) sur la surface externe du tube (6), dans la portée de l'angle central (ω) du miroir concave (1).

2. Convertisseur selon la revendication 1, **caractérisé en ce que** le miroir concave (1) est constitué de verre transparent recouvert d'un revêtement semiconducteur transparent constitué de métaux et/ou d'oxydes métalliques, de préférence d'oxyde indium-étain ITO.

3. Convertisseur selon la revendication 1, **caractérisé en ce que** le miroir concave (1) a une forme parabolique ou semi-cylindrique or cylindrique-parabolique.

4. Convertisseur selon la revendication 1, **caractérisé en ce qu'**il comprend une cellule photovoltaïque à base de silicium (5) située derrière le miroir concave (1) et éloignée du miroir concave (1) par un entrefer (9).

5. Convertisseur selon la revendication 1, **caractérisé en ce que** l'ensemble de cellules photovoltaïques (5) est formé par revêtement de la surface externe du tube (6) avec une cellule photovoltaïque en couche mince constituée de CdTe ou a:Si.

6. Convertisseur selon la revendication 5, **caractérisé en ce que** toute la surface du miroir (1) est recouverte de cellules photovoltaïques (5).
